# EUROPEAN PATENT APPLICATION

(11) **EP 4 764 032 A1**
(43) Date of publication of application: **24.06.2026**
(21) Application number: 24223131.4
(22) Date of filing: 23.12.2024
(51) Int. Cl.: C23F 1/18, C23C 22/52, C23G 1/10, H05K 3/06, H05K 3/38

(54) **PRETREATMENT METHOD TO ENHANCE NON-ETCH ADHESION PROMOTION**

(71) Applicant: Atotech Deutschland GmbH & Co. KG, 10553 Berlin (DE)
(72) Inventor: Belova-Magri, Valentina, 10553 Berlin (DE); Thoms, Martin, 10553 Berlin (DE); Michalik, Fabian, 10553 Berlin (DE); Hülsmann, Thomas, 10553 Berlin (DE)
(74) Representative: MKS IP Association

(57) **Abstract**

The instant invention relates to a method for treating a surface of a metal, a metal alloy or a metal oxide by contacting the at least one section of said metal, metal alloy or metal oxide with an acidic aqueous precoat solution comprising one or more than one tetrazole and/or triazole in combination with an acidic cleaning step which is performed either prior to or following the precoat step. It has surprisingly been found that when such pretreated surfaces are subsequently contacted with triazine compounds that the surfaces exhibit an improved resistance to delamination under thermal, humidity, and chemical stress conditions. This is demonstrated by increased adhesion strength and wedge void reduction.

## Description

### Field of the Invention

The instant invention relates to a method for treating a surface of a metal, a metal alloy or a metal oxide by contacting at least one section of said metal, metal alloy or metal oxide with an acidic aqueous precoat solution comprising one or more than one tetrazole and/or triazole in combination with an acidic cleaning step which is performed either prior to or following the precoat step. It has surprisingly been found that when such pretreated surfaces are subsequently contacted with triazine compounds that the surfaces exhibit an improved resistance to delamination under thermal, humidity, and chemical stress conditions. This is demonstrated by increased adhesion strength and wedge void reduction.

### Background of the Invention

Triazine compounds which might comprise silicon atoms are known in utilized in the manufacturing of electronic components, in particular in surface treatment solutions, e.g. for the treatment of metal surfaces and surfaces of organic materials as a preparation for further processing steps.

JP2016169300A (JP6436819B2) discloses 2,4-Diamine-substituted triazines which do not comprise silicon.

2,4,6-Triamine-substituted triazines are disclosed in Chem. Eur. J. 2009, 15, 6279-6288 and JP 2017002402 A (JP6370836B2). The use thereof in epoxy resins is disclosed in JP6392273B2.

WO2022/189646 discloses specific triazine silane compounds, oligomers, mixtures thereof as well as a respective storage and working solutions. Furthermore, the disclosure related to a synthesis method for said specific triazine silane compound, and the use of said working solution as a surface treatment solution for adhesion promotion.

Other heteroaromatic compounds such as azoles and triazoles are known for the treatment of metal surfaces.

US 2016/0368935 A1 relates to an azole silane compound, and a surface treatment solution using the azole silane compound, a surface treatment method and use thereof.

JP 2018016865 A discloses a triazole surface treatment agent containing a silane compound.

The article "Corrosion protection of copper with 3-glycidoxypropyltrimethoxysilane-based sol-gel coating through 3-amino-5-mercapto-1,2,4-triazole doping", Journal of Research on Chemical Intermediates, Volume 42, Issue 2, pages 1315 to 1328, 2015, discloses a study about corrosion protection of copper in a neutral medium by the formation of a sol-gel coating over the copper surface. It discloses that a 3-amino-5-mercapto-1,2,4-triazole-doped 3-glydidoxypropyltrimethoxysilane-based sol-gel coating on copper forms a thiolate bond to copper.

JPH 06279461 A refers to a surface treating agent for improving rust prevention on a metal surface, particularly a surface treating agent for copper foils used for copper clad laminate boards for printed circuits. The agent is an azole silane obtained by reacting 1H-1,2,4-triazole-3-thiol with 3-glycidoxypropyltrimethoxysilane at 80-200 °C.

The article "Recovery of rhodium-containing catalysts by silica-based chelating ion exchangers containing N and S donor atoms", Journal of Inorganica Chimica Acta 315 (2001), pages 183 to 190 discloses 4-amino-3-methyl-1,2,4-triazole-5-thione attached to the bifunctional spacer (3-glycidoxypropyl)trimethoxysilane prior to immobilization on silica.

WO2019/243180 discloses azole silane compounds, the synthesis thereof as well as respective solution and the use in surface treatment.

WO2020/178146 discloses the use of azole silane compounds in a method for increasing adhesion strength between a surface of a metal, a metal alloy or a metal oxide and a surface of an organic material.

Adhesion strength is related to the physical and chemical strength by which the metallic substrate and the organic material adhere by means of the adhesion layer.

Applying these molecules retains the desired adhesion after thermal, high humidity, and/or chemical stress. However, while the adhesion strength is improved, future developments require an even larger adhesion strength which cannot be achieved by the existing methods.

Another aspect related to adhesion strength is the avoidance of wedge void formation on non-etched copper surface. This means that during the typical follow-up steps such as lamination and curing, lasering, desmearing and reducing, wedge-like structures are formed at the interface between substrate and laminate. These so-called wedge voids are unwanted since they facilitate the peel off of the laminate. The wedge voids are often already seen as halo around the drilled hole indicating the chemical propagation to the substrate. While the above described triazine molecules can decrease the wedge void formation they cannot minimize to the extent that is necessary for further developments.

### Objective of the present Invention

It was therefore an objective of the present invention, based on the above-mentioned problems, to provide a method which does not exhibit the disadvantages regarding adhesion strength and wedge void and halo formation as described above.

### Description of the Figures

Figure 1 shows the halo Microscope images for different examples.
Figure 2 shows the halo microscope measurement.

### Description of the Invention

Above mentioned objective is solved by a method for treating a surface of a metal, a metal alloy or a metal oxide comprising the following steps:
(i) providing a substrate, comprising the metal, metal alloy or metal oxide on at least one side of the substrate,
(ii) optionally, contacting the at least one section of said metal, metal alloy or metal oxide with a differential etching solution comprising one or more than one acid and one or more than one oxidizing agent,
(ii-bis) optionally, contacting at least one section of said metal, metal alloy or metal oxide with an alkaline cleaning solution,
(iii) contacting at least one section of said metal, metal alloy or metal oxide with an acidic aqueous precoat solution comprising
   (iii-a) one or more than one tetrazole and/or triazole compound of formulas (Ia) and/or (lb) 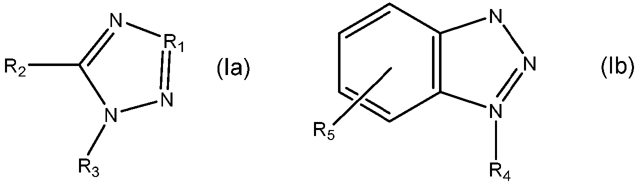
      R₁: N, CH, C-NH₂;
      R₂: NH₂, Ph, CH₂COOH, SH;
      R₃: H, CH₃, CH₂CH₃, CH₂CH₂-NH₂, CH₂CH₂-N(CH₃)₂;
      R₄: H, OH;
      R₅: H, CH₃;
   (iii-b) one or more than one organic and/or inorganic acid and/or salts thereof, and,
   (iii-c) one or more than one peroxide in a total amount of 1.0 wt-% or less, based on the total weight of the precoat solution, and
   (iii-d) halogenide ions in a total amount of 0 (0.00001) to 0.01 wt-%, based on the total weight of the precoat solution,
   (iii-e) metal ions in a total amount of 0 (0.001) to 0.5 wt-%, based on the total weight of the precoat solution,
   wherein during step (iii) the RSAI (Relative surface area increase) of said surface is not increased upon contacting with the precoat solution by more than 75%;
(iv) contacting at least one section of said metal, metal alloy or metal oxide with an acidic cleaning solution, preferably an acidic cleaning solution containing one or more than one acid, and optionally followed by rinsing of the at least one section of the metal, metal alloy or metal oxide,
(v) contacting of the at least one section of said metal, metal alloy or metal oxide with one or more than one triazine compound of formula (II) 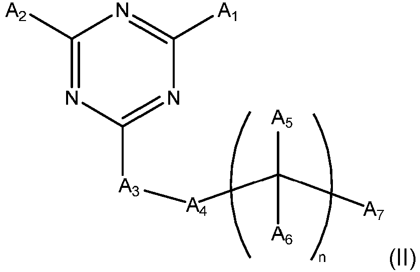 wherein A₁ and A₂ are independently selected from the group consisting of NH₂, N(A₁₀)₂, NH(NH₂), NH(CH₂)ₒNH₂, SH, SCH₃, and OCH₃; where A₁₀ is and hydrogen atom or alkyl group having 1 to 12 atoms.
   As is selected from the group consisting of -S-, -(CH₂)₂-S-, -NH-(CH₂)ₘ- and -NH-(CH₂)ₘ-NH-;
   A₄ is alkylene group which may content carbonyl, ethers, alpha-hydroxy ethers, carboxy, amide, imide, carbamide, carbamate groups
   m is an integer in the range from 2 to 12,
   n is an integer in the range from 2 to 12
   o is an integer in the range from 2 to 12,
   Wherein A₅ and A₆ may be the same or different and each represents a hydrogen atom, an alkyl group having 1 to 4 carbon atoms, a hydroxy group or a methoxy group,
   Wherein A₇ may be a hydrogen atom, an alkyl group having 1 to 4 carbon atoms, a hydroxy group, a methoxy group or -Si(OAa)s group
   A₈ independently denotes (CH₂-CH₂-O) ₚ-A₉, wherein independently
   p is 0, 1, 2, 3, or 4, and
   Ag denotes H or C1 to C5 alkyl
(vi) optionally, baking the substrate, preferably at 130°C for 30 min;
(vii) applying an organic material such that at least one section of the metal, metal alloy or metal oxide contacted with the triazine compound during step (v) is in contact with the applied organic material,
   and
(viii) optionally, subjecting the substrate and the organic material to a heat treatment with a temperature in the range from 115°C to 420°C, preferably in the range from 125°C to 300°C, more preferably in the range from 130°C to 200°C,
   wherein preferably the metal is copper, the metal alloy contains copper and the metal oxide is or contains a copper oxide;
   with the proviso that the steps are performed in the listed order with the exception that step (iii) and step (iv) can be exchanged, i.e. step (iii) is carried out after steps (ii) and (ii-bis) and then followed by step (iv) or step (iv) is carried out after steps (ii) and (ii-bis) and then followed by step (iii); and
   with the proviso that step (ii-bis) is mandatory if the method is carried out so that step (iv) is followed by step (iii).

The method according to the invention may comprise several rinsings with water between each process step. The method according to the invention may further comprise drying steps.

The steps are performed in the listed order with the exception that step (iii) and step (iv) can be exchanged, i.e. step (iii) is carried out after steps (ii) and (ii-bis) and then followed by step (iv) or step (iv) is carried out after steps (ii) and (ii-bis) and then followed by step (iii).

Step (ii-bis) is mandatory if the method is carried out so that step (iv) is followed by step (iii).

Hence, the steps have the order: step (i), [step (ii),] [step (ii-bis),] step (iii), step (iv), step (v), [step (vi),] step (vii), [step (viii)] (Precoat 1). Or the steps have the order: step (i), [step (ii),] step (ii-bis), step (iv), step (iii), step (v), [step (vi),] step (vii), [step (viii)] (Precoat 2). Optional steps are indicated by square brackets.

### Step (i) - Providing of substrate

In step (i) a substrate, comprising the metal, metal alloy or metal oxide on at least one side of the substrate, is provided.

The method according to the invention is preferred, wherein the metal, metal alloy or metal oxide is copper, aluminum, titanium, nickel, tin, iron, silver, gold, an alloy comprising at least one of the aforementioned metals (or an alloy comprising just the aforementioned metals), or a metal oxide of at least one of the aforementioned metals. The method according to the invention is especially preferred wherein the metal is copper, the metal alloy contains copper, and the metal oxide is or contains a copper oxide.

### Step (ii) - Differential etch

Step (ii) is an optional step: it can be advantageous to contact at least one section of said metal, metal alloy or metal oxide with a differential etching solution comprising one or more than one acid and one or more than one oxidizing agent.

This is optionally followed by rinsing of the at least one section of the metal, metal alloy or metal oxide,

The differential etching solution preferably comprises
(ii-a) at least one acid and
(ii-b) ferric ions and/or at least one peroxo compound.

The at least one acid (ii-a) is preferably selected from the group consisting of sulfuric acid, alkyl sulfonic acids such as methane sulfonic acid, aryl sulfonic acids such as phenylsulfonic acid, toluenesulfonic acid, nitric acid, phosphoric acid, formic acid, acetic acid, propionic acid and mixtures thereof.

According to the present invention the differential etching solution comprises in addition to the iron (III) salt or an iron (III) complex preferably sulfuric acid, chloride, copper (II), and optionally iron (II) salt.

In an alternative preferred embodiment, the oxidizing agent is a peroxo compound, preferably the peroxo compound is hydrogen peroxide.

In a more preferred embodiment, the differential etching solution comprises a mixture of an inorganic acid and a peroxo compound. More preferred, the differential etching solution comprises a mixture of sulfuric acid and hydrogen peroxide.

According to the present invention it is preferred, when the differential etching solution comprises in addition to the acid and/or to the one or more than one oxidizing agent a corrosion inhibitor, chloride, and copper(II).

### Step (ii-bis) - Alkaline cleaning step

Optionally, at least one section of said metal, metal alloy or metal oxide is contacted with an alkaline cleaning solution.

The alkaline cleaner solution is an aqueous solution containing at least one source of hydroxide ions (OH⁻). Such sources of hydroxide ions can be any water-soluble compounds which upon contact with water liberate or form otherwise hydroxide ions such as bases. Preferably, sources of hydroxide ions are selected from metal hydroxides such as alkali hydroxides and amines. The alkaline cleaner solution might contain carbonate, silicates, phosphates,surfactants and chelating agents.

Preferably, the pH of alkaline cleaning solution is 9 or higher. Preferred is an alkaline cleaning solution, wherein the solution has a pH of 9.6 or more, preferably the pH is in the range from 10.5 to 14, more preferably the pH is in the range from 11 to 14, most preferably the pH is in the range from 12 to 14.

Step (ii-bis) is designed to remove a wide range of contaminants from copper laminates, including grease, fingerprints, oxides, and any adhesion promoters that may be left on the copper surfaces due to poor resist stripping and/or by differential etching step (ii).

It has been surprisingly found that, if in the method of the present invention is carried out that step (iv) is followed by step (iii), step (ii-bis) is mandatory.

### Step (iii) - Precoat treatment

In step (iii), the at least one section of said metal, metal alloy or metal oxide is contacted with an acidic aqueous precoat solution comprising
(iii-a) one or more than one tetrazole and/or triazole compound of formulas (Ia) and/or (lb) 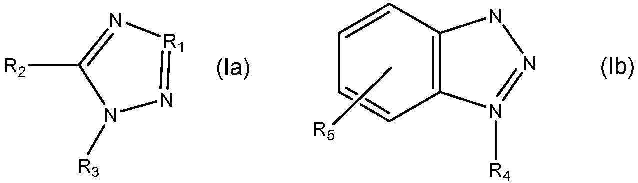
   R₁: N, CH, C-NH₂;
   R₂: NH₂, Ph, CH₂COOH, SH;
   R₃: H, CH₃, CH₂CH₃, CH₂CH₂-NH₂, CH₂CH₂-N(CH₃)₂;
   R₄: H, OH;
   R₅: H, CH₃;
(iii-b) one or more than one organic and/or inorganic acid and/or salts thereof, and,
(iii-c) one or more than one peroxide in a total amount of 1.0 wt-% or less, based on the total weight of the precoat solution, and
(iii-d) halogenide ions in a total amount of 0 (0.00001) to 0.01 wt- %, based on the total weight of the precoat solution,
(iii-e) metal ions in a total amount of 0 (0.001) to 0.5 wt-%, based on the total weight of the precoat solution,
wherein during step (iii) the RSAI (Relative Surface Area Increase) of said surface is not increased upon contacting with the precoat solution by more than 75%.

Preferably, the tetrazole and/or triazole (iii-a) are selected from 5-aminotetrazole (ATA), 5-phenyl-1H-tetrazole (PTA), 1H-Tetrazole-5-acetic acid (AAT), 1-[2-(Dimethylamino)ethyl]-1H-tetrazole-5-thiol (DMAE tetra), 3-amino-1,2,4-triazole (A-Tri), 3-amino-5-mercapto-1,2,4-triazole(A Marc-tri), tolyltriazole, 1-hydroxybenzotriazole (HB-tri) and mixtures thereof.

Preferred is a method of the present invention, wherein the one or more than one organic and/or inorganic acid and salts thereof (iii-b) are selected from the group consisting of sulfuric acid, nitric acid, hydrochloric acid, phosphoric acid, mono-carboxylic acids, hydroxy-mono-carboxylic acids, di-carboxylic acids, hydroxy-di-carboxylic acids, tri-carboxylic acids, hydroxy-tri-carboxylic acids, amino carboxylic acids, and salts thereof; preferably selected from the group consisting of mono-carboxylic acids, hydroxy-mono-carboxylic acids, di-carboxylic acids, hydroxy-di-carboxylic acids, tri-carboxylic acids, hydroxy-tri-carboxylic acids, and salts thereof; most preferably selected from the group consisting of mono-carboxylic acids, hydroxy-mono-carboxylic acids, di-carboxylic acids, hydroxy-di-carboxylic acids, and salts thereof.

Particularly preferred specific organic and/or inorganic acids and salts (iii-b) thereof are selected from the group consisting of sulfuric acid, nitric acid, hydrochloric acid, formic acid, acetic acid, propionic acid, caprylic acid, glycolic acid, n-butyric acid, isobutyric acid, acrylic acid, crotonic acid, isocrotonic acid, oxalic acid, malonic acid, succinic acid, adipic acid, maleic acid, acetylenedicarboxylic acid, lactic acid, glyceric acid, tartaric acid, malic acid, citric acid, threonine, tryptophane, phenylalanine, and salts thereof.

Most preferred is a method of the present invention, wherein the one or more than one organic and/or inorganic acid and salts thereof (iii-b) are selected from the group consisting of sulfuric acid, nitric acid, formic acid, acetic acid, lactic acid, malic acid, citric acid, and salts thereof, most preferably sulfuric acid, citric acid, acetic acid, and salts thereof.

Preferably, the one or more than one peroxide (iii-c) is selected from the group consisting of hydrogen peroxide, organic peroxides, and inorganic peroxides.

Preferred organic peroxides are selected from the group consisting of organic peroxy acids and non-acidic alkyl peroxides. A preferred organic peroxy acid is peracetic acid. A preferred non-acidic alkyl peroxide is tert-butyl hydroperoxide.

Preferred inorganic peroxides are selected from the group consisting of inorganic peroxy acids and metal peroxides. Preferred inorganic peroxy acids are peroxymonosulfuric acid and peroxydisulfuric acid. Preferred metal peroxides are alkali metal peroxids, more preferably sodium peroxide and potassium peroxydisulfate.

More preferred is a method of the present invention, wherein the one or more than one peroxide (iii-c) is selected from the group consisting of hydrogen peroxide and organic peroxides. In particular, in some cases a method of the present invention is preferred, wherein the acidic aqueous precoat solution is substantially free of, preferably does not comprise, inorganic peroxy acids; in a more preferred case, is substantially free of, preferably does not comprise, inorganic peroxy acids and metal peroxides.

Most preferred is a method of the present invention, wherein the one or more than one peroxide comprises hydrogen peroxide, preferably is hydrogen peroxide. Most preferably, in the acidic aqueous precoat solution hydrogen peroxide is the only peroxide compound. Hydrogen peroxide only consists of hydrogen and oxygen, and, thus, does not contaminate the working environment with additional compounds or elements.

Most preferred is a method of the present invention, wherein in the acidic aqueous non-etching solution hydrogen peroxide is the only peroxide and the total amount of peroxides in the acidic aqueous precoat solution is 1.0 wt-% or less, based on the total weight of the acidic aqueous precoat solution, preferably 0.9 wt-% or less, more preferably 0.8 wt-% or less, most preferably 0.7 wt-% or less, even most preferably 0.6 wt-% or less. In this case the total amount of peroxides equals the total amount of hydrogen peroxide.

Preferredly, halogenide ions(iii-d) are sources of chloride ions and sources of bromide ions. Fluoride ions may form hydrofluoric acid in acidic media which is very toxic and difficult to handle whereas iodic ions may be oxidisedo in the solution rendering them ineffective. Examples of suitable sources of chloride ions are water-soluble chloride salts. Preferably, the at least one source of chloride ions is selected from the group consisting of hydrogen chloride, water soluble metal chlorides such as alkali chlorides like lithium chloride, sodium chloride, potassium chloride and caesium chloride, earth alkaline chlorides like manganese chloride, calcium chloride, strontium chloride and barium chloride, transition metal chlorides like manganese chloride, iron chloride, cobalt chloride, nickel chloride, copper chloride and zinc chloride, ammonium chloride and mixtures thereof. More preferably, at least one source of chloride ions is selected from the group consisting of hydrogen chloride, alkali chlorides and ammonium chloride. Examples of suitable sources of bromide ions are water-soluble bromide salts. Preferably, the at least one source of bromide ions is selected from the group consisting of hydrogen bromide, water soluble metal bromides such as alkali bromides like lithium bromide, sodium bromide, potassium bromide and cesium bromide, earth alkaline bromides like manganese bromide, calcium bromide, strontium bromide and barium bromide, transition metal bromides like manganese bromide, iron bromide, cobalt bromide, nickel bromide, copper bromide and zinc bromide, ammonium bromide and mixtures thereof.

Preferably, metal ions (iii-e) are selected from copper and/or zinc compounds. Examples of copper compounds include copper formate, copper acetate, copper oxalate, copper (I) chloride, copper (II) chloride, copper (I) bromide, copper (II) bromide, copper iodide, copper hydroxide, copper phosphate, copper sulfate, and copper nitrate. A single copper compound, or combinations of two or more copper compounds, can be used as an auxiliary agent. Examples of zinc compounds include zinc oxide, zinc formate, zinc acetate, zinc oxalate, zinc lactate, zinc citrate, zinc sulfate, zinc nitrate, zinc phosphate, zinc chloride, zinc bromide, and zinc iodide.

In step (iii) of the method of the present invention the acidic aqueous non-etching solution is contacted with the substrate comprising said surface such that the adhesion strength is increased. Preferred is a method of the present invention, wherein in step (iii) the contacting is carried out for 5 seconds to 600 seconds, preferably for 10 seconds to 300 seconds, more preferably for 15 seconds to 150 seconds, most preferably for 20 second to 90 seconds. Etching of the metal surface provides certain advantages in order to increase the adhesion between layers. On the other hand, these roughened metal surfaces show a decreased performance in the final product and, hence, etching/roughening shall be avoided.

Therefore, it was a goal of the invention to provide a step that exhibits low or even no etching, considering an etch process as any process that provides metal etch above 0.2 µm, with RSAI up to 300%. One can differentiate between so-called non-etching adhesion promotion (NEAP) and low-etching adhesion promotion (LEAP).
a) NEAP (Non-etching adhesion promotion):
   i. for cleaning steps prior to precoat treatment: NEAP is below 50 nm etch, due to the fact that metal oxide must be removed by cleaning step(s) and is counted as metal loss; Surface morphology of metal substrate is not affected by cleaning steps
   ii. For Precoat treatment+ Triazine compound Coating - no etch process
   iii. NEAP - RSAI change from initial metal substrate to treated should be less than 10%, preferred less than 5%
b) LEAP (Low-etching adhesion promotion):
   i. etch below 0.2 µm or/ and RSAI change from initial metal substrate to treated should be in between 5 to 75%
   ii. For Precoat treatment+ Triazine compound Coating - LEAP (etch below 150 nm)

The metal surface roughness is represented by RSAI (Relative Surface Area Increase) and it is measured by Atomic Force Microscopy (AFM), due to its high resolution in measuring surface roughness in nano scale.

### Step (iv) - Acidic cleaner

In step (iv), at least one section of said metal, metal alloy or metal oxide is contacted with an acidic cleaning solution, preferably an acidic cleaning solution containing one or more than one acid selected from the group consisting of sulphuric acid, alkyl sulphonic acids, aryl sulphonic acids, nitric acid, phosphoric acid, formic acid, acetic acid, propionic acid and mixtures thereof; and optionally followed by rinsing of the at least one section of the metal, metal alloy or metal oxide.

Step (iv) designed for removal of a wide variety of contaminants from copper laminate, including oxides, very effective in removing any residual conversion coatings.

### Step (v) - Contacting with triazine compound

In step (v), at least one section of the metal, metal alloy or metal oxide is contacted with one or more than one triazine compound of formula (II) 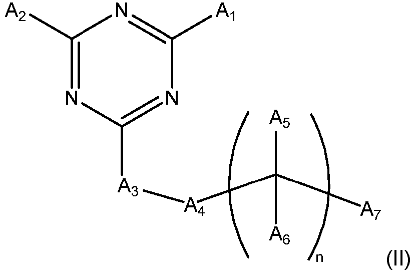 wherein A₁ and A₂ are independently selected from the group consisting of NH₂, N(A₁₀)₂, NH(NH₂), NH(CH₂)ₒNH₂, SH, SCH₃, and OCH₃; where A₁₀ is a hydrogen atom or alkyl group having 1 to 12 atoms.
As is selected from the group consisting of -S-, -(CH₂)₂-S-, -NH-(CH₂)ₘ- and -NH-(CH₂)ₘ-NH-;
A₄ is alkylene group which may content carbonyl, ethers, alpha-hydroxy ethers, carboxy, amide, imide, carbamide, carbamate groups
m is an integer in the range from 2 to 12,
n is an integer in the range from 2 to 12
o is an integer in the range from 2 to 12,
Wherein A₅ and A₆ may be the same or different and each represents a hydrogen atom, an alkyl group having 1 to 4 carbon atoms, a hydroxy group or a methoxy group,
Wherein A₇ may be a hydrogen atom, an alkyl group having 1 to 4 carbon atoms, a hydroxy group, a methoxy group or -Si(OA₈)₃ group
A₈ independently denotes (CH₂-CH₂-O) ₚ-A₉, wherein independently
p is 0, 1, 2, 3, or 4, and
Ag denotes H or C1 to C5 alkyl

In one preferred embodiment the triazine compounds are selected from triazine compounds of formula (II), wherein A₁ and A₂ are NH₂ and A₃ is -(CH₂)₂-S-.

Particularly preferred, the triazine compounds are selected from triazine compounds of formula (III) and/or formula (IV)

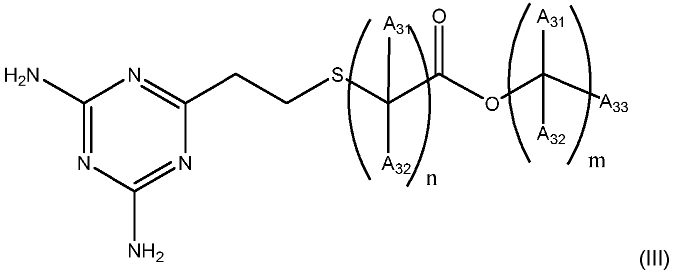

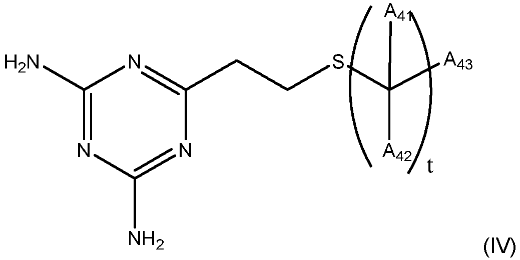

Such compounds have been disclosed in JP6436819B2.

In an alternative preferred embodiment the triazine compounds are selected from triazine compounds of formula (II), wherein A₁ and A₂ are NH₂ and A₃ is -NH-(CH₂)ₘ-.

Particularly preferred, the triazine compounds are selected from triazine compounds of formula (V) and/or formula (VI)

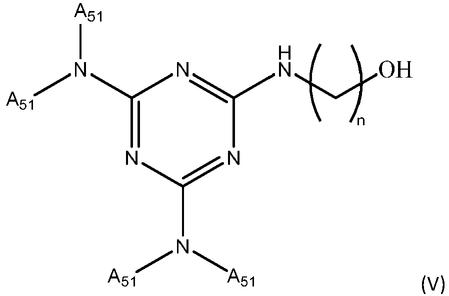

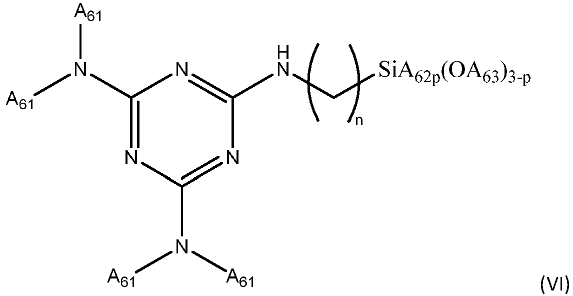

Such compounds have been disclosed in JP6370836B2.

In an even other alternative preferred embodiment the triazine compounds are selected from triazine compounds of formula (II), wherein A₁ and A₂ are NH₂ and A₃ is -(CH₂)₂-S.

Particularly preferred, the triazine compounds are selected from triazine compounds of formula (VII) and/or formula (VIII)

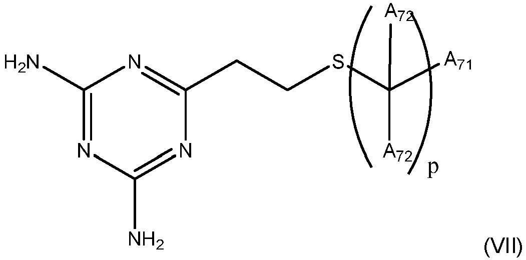

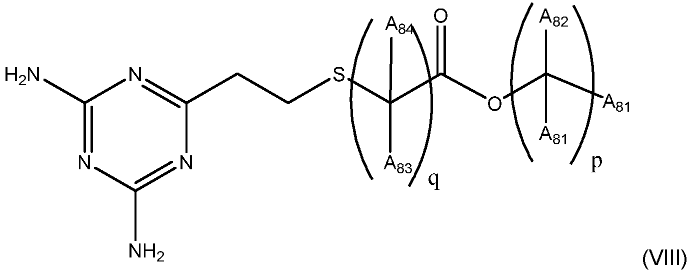

Such compounds have been disclosed in WO2017195456A1.

In an even other alternative preferred embodiment the triazine compounds are selected from triazine compounds of formula (IX) 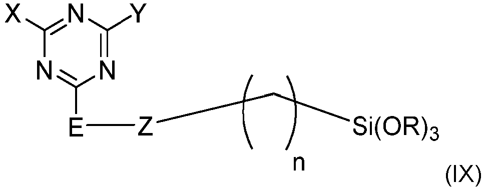 wherein
X and Y are independently selected from the group consisting of NH₂, NH(NH₂), NH(CH₂)ₒNH₂, SH, SCH₃, and OCH₃;
E is selected from the group consisting of -S- and -NH-(CH₂)ₘ-NH-;
Z is selected from the group consisting of 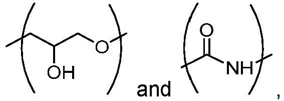
m is an integer in the range from 2 to 12,
n is an integer in the range from 1 to 12,
o is an integer in the range from 2 to 12,
R independently denotes (CH₂-CH₂-O) ₚ-T, wherein independently
p is 0, 1, 2, 3, or 4, and
T denotes H or C1 to C5 alkyl

In an even more preferred embodiment the triazine compound is the compounds of formula (X)

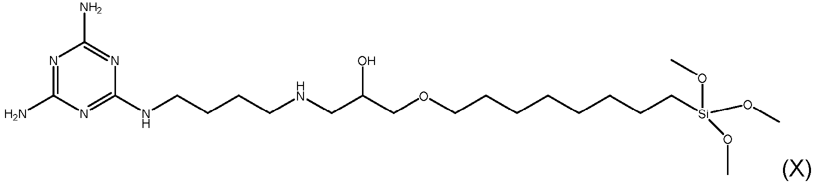

### Step (vi) - Baking

Step (vi) is an optional step. The substrate is baked, preferably at 130°C for 30 min.

### Step (vii) - Lamination

In step (vii) an organic material is applied such that the at least one section of the metal, metal alloy or metal oxide contacted with the triazine compound during step (v) is in contact with the applied organic material,

A method according to the present invention is preferred, wherein the organic material is a non-conductive organic material, preferably a non-conductive organic polymer.

### Step (viii) - Heat treatment

In step (viii) the substrate and the organic material are subjected to a heat treatment with a temperature in the range from 115°C to 420°C, preferably in the range from 125°C to 300°C, more preferably in the range from 130°C to 220°C.

The invention is further explained by the following non-limiting examples.

### Examples

### Measurements:

### 1) Adhesion evaluation via peel strength test:

For each sample obtained after the lamination, peel strength was determined:
(1) Initial,
(2) after 96 hours HAST (HAST: Highly-Accelerated Temperature and Humidity Stress Test, JESD22-A1 10-B, conditions: 130°C, 85 % rh, HAST chamber: EHS-221M),
(3) after 12 cycles IR Reflow (IPC/JEDEC J-STD-020D thermal reliability, simulation of soldering process with temperature peak at 280 °C).

To determine the peel strength, several strip-type fragments have been prepared from each specimen by adhering the respective copper foils to a rigid board (identical size as the copper foils) in such a way that the rigid board faced the insulating film. As a result, copper surfaces with structurally enforced insulating films were obtained.

The obtained copper surfaces with structurally enforced insulating films were then cured in an oven: copper surfaces with Ajinomoto ABF GL102 material at 200°C for 90 minutes.

Afterwards, each copper surface with structurally enforced insulating films was sliced into said strip-type fragments (10x100 mm, Bugard drilling/routing).

The strip-type fragments were subjected to a peel force measuring machine (Roell Zwick Z010) to individually evaluate the peel strength (angle: 90°, speed: 50 mm/min) which is needed to delaminate the copper surface from its respective structurally enforced insulating films. Typically, the higher the peel strength needed to avoid delamination the better is the adhesion.

### 2) Halo Evaluation

### Sample preparation:

In order to evaluate the halo, the copper samples have been prepared by adhering the respective insulating films to copper panels. As a result, copper surfaces with structurally enforced insulating films were obtained.

The obtained copper surfaces with structurally enforced insulating films were then semicured in two steps in the ovens: copper surfaces with GL102 material at 130°C for 30 minutes followed by 180°C for 30 minutes.

After completing the lamination and semi-curing step, the copper panels were lasered with UV-laser to drill the Blind Micro Vias (BMV). Thereafter, the substrates were subjected to the desmear and reduction condition steps. In particular, these included a sweller treatment under alkaline conditions with Securiganth MV Sweller (Product from Atotech Deutschland GmbH & Co. KG); a permanganate treatment under alkaline conditions with Securiganth MV Etch P (Product from Atotech Deutschland GmbH & Co. KG) and a reduction conditioner treatment under acidic conditions with Securiganth MV Reduction Conditioner (Product from Atotech Deutschland GmbH & Co. KG). After each step the samples were rinsed with water.

The lamination material exhibits a thickness of ca. 10 µm or ca. 15 µm for wedge void and halo and 35 µm in case of adhesion investigations, respectively.

The investigated test Blind Micro Vias (BMV) are manufactured as a test grid on surface treated and Ajinomoto Buildup Film (ABF) laminated test vehicles by utilizing Laser Drilling technology. The halo data are obtainable after sending the prepared test vehicles through entire Desmear process (Sweller, Permanganate, Reduction Conditioner) as described above.

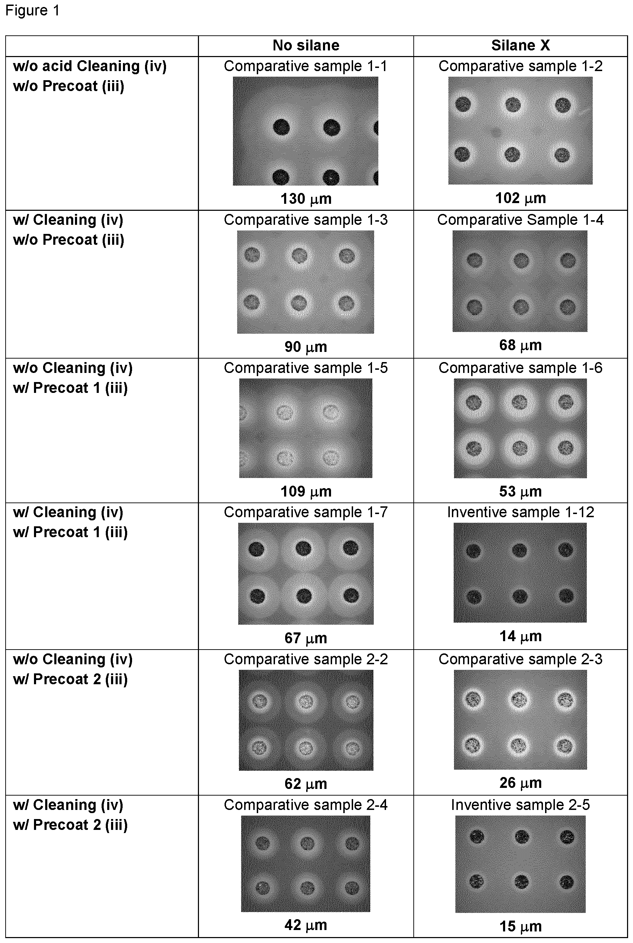

Halo measurement is performed by camera (CCD) supported light microscopy. Hereby, the microscope must be operated in epi-illumination mode. All image generation must be carried out by using Darkfield (DF) filter setting. A magnification factor of approx. 200x is typically used. Pictures depicting the halo measurement for different examples can be found in Figure 1.

The fully processed test vehicles are firmly installed on the measurement table and the BMV capture pad must be set as optical focus. CCD exposure time must be adjusted to the maximum possible contrast of halo boundaries. Hereby, the capture pad should appear as bright as possible.

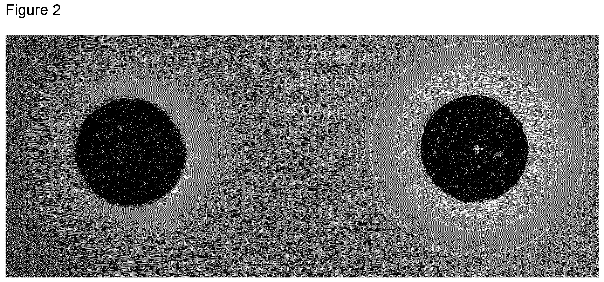

The visible diameter of the via hole (or clean capture pad), the inner (innermost) and the outer (outermost) appearing halo like boundaries are measured and recorded according to Figure 2. The actual halo values can now be calculated by using following relations.
1. Outer Halo([µm] = (Outermost Diameter[µm] - Diameter of Via Hole[µm])/2
2. Inner Halo[µm] = (Inner Diameter of Halo[µm] - Diameter of Via Hole[µm])/2

Typically, this process is iterated at least 3 times at random test vias to enable minimal statistical statements.

### 3) Wedge void evaluation

In addition, substrates were subjected to Focused Ion Beam (FIB) cuts and subsequent Scanning Electron Microscopy (SEM) measurement. This method allows to analyse the copper adhesion in the vicinity of a Blind Micro Via (BMV), also known as wedge void.

### A) Sample preparation

Table 1 and Table 2 give an overview of the reaction steps for Precoat 1 and Precoat 2, respectively. The single steps are then described in more detail thereafter.

**Table 1: with Precoat 1 (low etch)**

| Step | Process | Make up | Temp | Dwell time | Remarks |
|---|---|---|---|---|---|
| (i) | Providing copper substrate | | | | |
| | Annealing | | 160°C | | 1h |
| (ii) | Differential Etch (opt.) | Ecoflash* | 35°C | Depending on etch rate | Target etch depth is 0,5µm & 1µm |
| | Triple cascade rinse | DI water | | 20s each step | |
| | Dry (opt.) | | | Up to dry | Hot air dryer |
| (iii) | Precoat 1 (Low-etch) | | 35 °C | 30-60s | 0,01-0,05 µm |
| | Triple cascade rinse | DI water | RT | 20s each step | |
| | Dry (opt.) | | | Up to dry | Hot air dryer |
| (iv) | Acidic clean | H₂SO₄ 5 vol% | RT | 20s each step | |
| | Triple cascade rinse | DI water | RT | 20s each step | |
| | Dry | | | Up to dry | Hot air dryer |
| (v) | Adhesion Promoter | Diff. triazines | RT | 60s | |
| | Triple cascade rinse | DI water | RT | 20s each step | |
| | Dry | | | Up to dry | Hot air dryer |
| (vi) | Baking (opt.) | | 130°C | 30 min | Air ventilated oven |
| (vii) | Lamination | | | | |

| | | | | | |
|---|---|---|---|---|---|
| RT: ambient; (opt.): optional (*) Products from Atotech Deutschland GmbH & Co. KG | | | | | |

**Table 2: with Precoat 2 (non-etch)**

| Step | Process | Make up | Temp | Dwell time | Remarks |
|---|---|---|---|---|---|
| (i) | Providing copper substrate | | | | |
| | Annealing | | 160°C | | 1h |
| (ii) | Differential Etch (opt.) | Ecoflash* | 35°C | Depending on etch rate | Target etch depth is 0,5µm & 1µm |
| | Triple cascade rinse | DI water | | 20s each step | |
| | Dry (opt.) | | | Up to dry | Hot air dryer |
| (ii-bis) | aqueous alkaline solution | pH 14 | 50°C | 20s - 300 s | |
| | Triple cascade rinse | DI water | | 20s each step | |
| (iv) | Acidic clean | H₂SO₄ 5 vol% | RT | 20s each step | |
| | Triple cascade rinse | DI water | RT | 20s each step | |
| | Dry (opt.) | | | Up to dry | Hot air dryer |
| (iii) | Precoat 2 (No etch) | | RT - 35 °C | 30-60s | |
| | Triple cascade rinse | DI water | RT | 20s each step | |
| | Dry | | | Up to dry | Hot air dryer |
| (v) | Adhesion Promoter | Diff. triazines | RT-35°C | 60s | |
| | Triple cascade rinse | DI water | RT | 20s each step | |
| | Dry (opt.) | | | Up to dry | Hot air dryer |
| (vi) | Baking (opt.l) | | 130°C | 30 min | Air ventilated oven |
| (vii) | Lamination | | | | |

| | | | | | |
|---|---|---|---|---|---|
| RT: ambient; (opt.): optional (*) Products from Atotech Deutschland GmbH & Co. KG | | | | | |

### Step (i): Providing the substrate having on at least one surface a copper surface:

Copper foils having a copper surface (150 mm x 75 mm x 35 µm, plated in house) were used. Under simplified laboratory conditions, copper foils without substrates are used for the examples.

For wedge void and halo investigations plated copper panels were used.

The preparation conditions are as follows:
Electrolytically plated copper type:
foil (adhesion test)
panels (wedge void)

### Step (ii): Differential Etch:

The copper surfaces of the copper foils were treated by Ecoflash, Cupraetch SR or Cupraetch PT (Products from Atotech Deutschland GmbH & Co. KG) to achieve 0.5 or 1µm etch depth. After the etch-cleaning the etch-cleaned copper surfaces were rinsed with water for approximately 30 seconds and optionally dried. As a result, etch-cleaned and rinsed copper surfaces were obtained.

### Step (ii-bis): Treating the copper surface with aqueous alkaline solution (only in Precoat 2):

The copper surfaces of all substrates were treated with aqueous alkaline solution (50 °C, dipping for 300 s or spraying 30 s). After the treatment the treated copper surfaces of all copper substrates were rinsed with cold DI water for approximately 30 s (triple cascade).

### Step (iii): Treating the copper surface with surface treatment solution ("Precoat 1 or 2"):

Copper surfaces of all substrates were immersed for 60 s at RT - 35 °C into a surface treatment aqueous solution containing an azole chemistry, acid and hydrogen peroxide. After the treatment step copper surfaces of all copper substrates were rinsed with DI water for approximately 30 s (triple cascade).

### Step (iv): Treating the copper surface with acidic solution:

The copper surfaces of all copper substrates were cleaned at room temperature for 20-30 seconds by using a 5 vol% sulfuric acid. After the cleaning step copper surfaces of all copper substrates were rinsed with cold DI water for approximately 30 s (triple cascade).

### Step (v): Contacting the copper surfaces with triazine compound:

Copper surfaces of all substrates were immersed for 60 s at 25°C into a coating solution containing a triazine compound and solvents. If water is present, the pH of the coating solution was up to 13.3 (adjusted with sodium hydroxide).

Afterwards the resulting copper surfaces of all copper substrates were rinsed with water for approximately 30 seconds and dried. As a result, triazine-treated and dried copper surfaces of all copper substrates were obtained.

### Step (vi): Baking:

The copper substrates containing the triazine-treated copper surfaces were then annealed for 30 minutes at 130°C to remove remaining moisture from the surface. Note: this thermal treatment step is typically known as baking. These substrates containing copper surfaces were subsequently subjected to laminating a build-up film (see text below).

### Step (vii): Applying the organic material onto the copper surface of the substrates:

In a laminating step, an insulating film was vacuum laminated onto the copper substrates of all samples in a clean room with a room temperature in the range from 20 to 25°C and with a relative humidity of 50 to 60% by using a vacuum laminator.

After lamination, laminated copper surfaces were obtained.

For Precoat 1, 23 samples have been prepared, i.e. Samples 1-1 to 1-23.

For Precoat 2, 58 samples have been prepared, i.e. Samples 2-1 to 2-58.

The samples have been evaluated regarding their peel strength and their halo formation.

Particular conditions for each sample as well as peel strength and halo values are given in Table 3, for Precoat 1, and Table 4, for Precoat 2, respectively.

### Peel strength

The experiments show that the inventive examples exhibit a good adhesion strength, here expressed as peel strength.

### Halo and wedge void evaluation

The experiments show that the inventive examples exhibit a good behavior regarding avoidance of wedge void formation, here expressed as halo sizes.

**Table 3: with Precoat 1**

| Sample | Inventive (Inv) / Comparative (Comp) | Differential etching solution, 1 µm etched (ii) | Precoat 1 (iii) | | | | Acidic Cleaner (iv) | Adhesion promoter (v) | Peel strength [N/cm] | | | Outer halo size [µm] |
|---|---|---|---|---|---|---|---|---|---|---|---|---|
| | | | Acid type | Additive structure | Additive conc [g/L] | H₂O₂ [mUL] | | | Initial | 12x Reflow | HAST | |
| 1-1 | Comp | Ecoflash* | none | none | - | - | none | none | | | | 130 |
| 1-2 | Comp | Ecoflash* | none | none | - | - | none | X | | | | 102 |
| 1-3 | Comp | Ecoflash* | none | none | - | - | yes | none | 4.2 | 3.0 | 1.2 | 90 |
| 1-4 | Comp | Ecoflash* | none | none | - | - | yes | X | 6.1 | 5.4 | 4.2 | 68 |
| 1-5 | Comp | Ecoflash* | sulfuric | ATA+PTA | 0.8 | 10 | none | none | 4.0 | 3.4 | 1.6 | 109 |
| 1-6 | Comp | Ecoflash* | sulfuric | ATA+PTA | 0.8 | 10 | none | X | 5.8 | 5.4 | 4.3 | 53 |
| 1-7 | Comp | Ecoflash* | sulfuric | PTA | 0.2 | 10 | yes | none | 4.3 | 3.7 | 1.5 | 67 |
| 1-8 | Comp | Ecoflash* | sulfuric | ATA | 0.6 | 10 | yes | none | 4.4 | 4.0 | 1.6 | 59 |
| 1-9 | Comp | Ecoflash* | sulfuric | ATA+PTA | 0.8 | 10 | yes | none | 4.2 | 3.6 | 1.8 | 130 |
| 1-10 | Inv | Ecoflash* | sulfuric | PTA | 0.2 | 10 | yes | X | 5.7 | 5.6 | 4.1 | 30 |
| 1-11 | Inv | Ecoflash* | sulfuric | ATA | 0.6 | 10 | yes | X | 5.8 | 5.3 | 4.3 | 18 |
| 1-12 | Inv | Ecoflash* | sulfuric | ATA+PTA | 0.8 | 10 | yes | X | 6.1 | 5.9 | 4.8 | 14 |
| 1-13 | Inv | Ecoflash* | sulfuric | ATA+PTA | 0.8 | 5 | yes | X | 6.2 | 6.1 | 4.7 | 16 |
| 1-14 | Inv | Ecoflash* | sulfuric | ATA+PTA | 0.8 | 15 | yes | X | 5.8 | 5.6 | 4.8 | 15 |
| 1-15 | Inv | Ecoflash* | methanesulfonic | ATA+PTA | 0.8 | 5 | yes | X | 6.3 | 5.4 | 4.7 | 13 |
| 1-16 | Inv | Ecoflash* | methanesulfonic | ATA+PTA | 0.8 | 10 | yes | X | 6.5 | 6.2 | 4.6 | 14 |
| 1-17 | Inv | Ecoflash* | methanesulfonic | ATA+PTA | 0.8 | 15 | yes | X | 6.4 | 6.1 | 4.8 | 14 |
| 1-18 | Comp | Cupraetch SR* | sulfuric | ATA+PTA | 0.8 | 10 | yes | none | | | | 60 |
| 1-19 | Inv | Cupraetch SR* | sulfuric | ATA+PTA | 0.8 | 10 | yes | X | | | | 18 |
| 1-20 | Comp | Cupraetch PT* | sulfuric | ATA+PTA | 0.8 | 10 | yes | none | 5.6 | 5.0 | | 97 |
| 1-21 | Inv | Cupraetch PT* | sulfuric | ATA+PTA | 0.8 | 10 | yes | X | 6.5 | 5.9 | 4.4 | 13 |
| 1-22 | Comp | none | sulfuric | ATA+PTA | 0.8 | 10 | yes | none | 5.0 | | 1.2 | 80 |
| 1-23 | Inv | none | sulfuric | ATA+PTA | 0.8 | 10 | yes | X | 6.0 | 5.8 | 4.2 | 13 |

| | | | | | | | | | | | | |
|---|---|---|---|---|---|---|---|---|---|---|---|---|
| (*) Products from Atotech Deutschland GmbH & Co. KG ATA: 5-amino tetrazole; PTA: 5-phenyl-1H-tetrazole; AAT: 1H-Tetrazole-5-acetic acid | | | | | | | | | | | | |

Precoat 1 chemistry:
- includes Cu ions source (5 g/l of copper or 20 g/l copper sulphate)
- includes chloride ions (15 mg/l)
- acids H₂SO₄ (50%, 50 ml/l), MSA (80%, 50 ml/l), Acetic acid (100%, 50 ml/l). Acid amount presented in the precoat 1 influences the results.

Adhesion promoter: examples in the table with a triazine concentration of 1.5 wt.% in the DEGBE: H₂O (1:1 ratio). DEGBE is a diethylene glycol monobutyl ether.

Peel strength done with GL102 35 µm, Halo measurements with GL102 of 15 µm

**Table 4: with Precoat 2**

| Sam ple | Inventive (Inv) / Comparative (Comp) | Differential Etching solution, 1 µm etched (ii) | Alkaline Cleaner (ii-bis) | Acidic Cleaner (iv) | Precoat 2 (iii) | | | | | Adhesion Promoter | Peel strength [N/cm] | | | Outer halo size [µm] |
|---|---|---|---|---|---|---|---|---|---|---|---|---|---|---|
| | | | | | Acid type | Additive structure | Additive conc [g/L] | pH | H₂O₂ [mUL] | | Initial | 12x Reflow | HAST | |
| 2-1 | Comp | Ecoflash* | yes | yes | none | none | - | - | - | none | 6.8 | | 1.5 | 120 |
| 2-2 | Comp | Ecoflash* | none | none | acetic | ATA | 3.0 | 3 | 1 | none | 4.1 | 3.2 | 1.9 | 62 |
| 2-3 | Comp | Ecoflash* | none | none | acetic | ATA | 3.0 | 3 | 1 | X | | | | 26 |
| 2-4 | Comp | Ecoflash* | yes | yes | acetic | ATA | 3.0 | 3 | 1 | none | 4.0 | 3.5 | 2.0 | 42 |
| 2-5 | Inv | Ecoflash* | yes | yes | acetic | ATA | 3.0 | 3 | 1 | X | 6.4 | 6.7 | 4.8 | 15 |
| 2-6 | Comp | Ecoflash* | yes | yes | acetic | ATA | 4.5 | 3 | 1 | none | 4.2 | 3.6 | 2.0 | 42 |
| 2-7 | Inv | Ecoflash* | yes | yes | acetic | ATA | 4.5 | 3 | 1 | X | 6.2 | 5.8 | 4.4 | 13 |
| 2-8 | Comp | Ecoflash* | yes | yes | acetic | ATA | 3.0 | 6 | 1 | X | 6.3 | 5.8 | 3.9 | 53 |
| 2-9 | Comp | Ecoflash* | yes | yes | acetic | ATA | 3.0 | 9 | 1 | X | | | | 68 |
| 2-10 | Comp | Cupraetch SR (0.5 um)* | yes | yes | acetic | ATA | 3.0 | 3 | 1 | none | 7.0 | 7.0 | 4.5 | 25 |
| 2-11 | Inv | Cupraetch SR (0.5 um)* | yes | yes | acetic | ATA | 3.0 | 3 | 1 | X | 7.3 | 6.7 | 4.3 | 12 |
| 2-12 | Comp | Cupraetch PT* | yes | yes | acetic | ATA | 3.0 | 3 | 1 | none | 4.0 | 3.0 | 2.0 | 48 |
| 2-13 | Inv | Cupraetch PT* | yes | yes | acetic | ATA | 3.0 | 3 | 1 | X | 5.5 | 5.4 | 4.4 | 15 |
| 2-14 | Comp | none | yes | yes | acetic | ATA | 3.0 | 3 | 1 | none | 5.3 | 5.2 | 2.3 | 45 |
| 2-15 | Inv | none | yes | yes | acetic | ATA | 3.0 | 3 | 1 | X | 5.6 | 5.4 | 4.5 | 14 |
| 2-16 | Comp | Ecoflash* | yes | yes | citric | ATA | 3.0 | 3 | 1 | none | 4.3 | 3.5 | 2.1 | 38 |
| 2-17 | Inv | Ecoflash* | yes | yes | citric | ATA | 3.0 | 3 | 1 | X | 6.6 | 5.9 | 4.8 | 14 |
| 2-18 | Comp | Ecoflash* | yes | yes | citric | ATA | 4.5 | 3 | 1 | none | 4.1 | 3.8 | 1.9 | 41 |
| 2-19 | Inv | Ecoflash* | yes | yes | citric | ATA | 4.5 | 3 | 1 | X | 6.3 | 5.8 | 4.7 | 15 |
| 2-20 | Inv | Ecoflash* | yes | yes | citric | ATA | 3.0 | 6 | 1 | X | 6.4 | 6.0 | 4.8 | 12 |
| 2-21 | Comp | Ecoflash* | yes | yes | citric | ATA | 3.0 | 9 | 1 | X | | | | 53 |
| 2-22 | Comp | Ecoflash* | yes | yes | sulfuric | ATA | 3.0 | 1 | 1 | X | | | | 74 |
| 2-23 | Inv | Ecoflash* | yes | yes | sulfuric | ATA | 3.0 | 2 | 1 | X | 6.4 | 6.1 | 4.4 | 18 |
| 2-24 | Inv | Ecoflash* | yes | yes | sulfuric | ATA | 3.0 | 3 | 1 | X | 6.2 | 5.8 | 4.5 | 19 |
| 2-25 | Inv | Ecoflash* | yes | yes | gluconic | ATA | 3.0 | 2 | 1 | X | 6.3 | 5.9 | 4.5 | 15 |
| 2-26 | Inv | Ecoflash* | yes | yes | gluconic | ATA | 3.0 | 4 | 1 | X | 6.6 | 6.2 | 4.7 | 14 |
| 2-27 | Comp | Ecoflash* | yes | yes | Methanesulfonic | ATA | 3.0 | 1 | 1 | X | | | | 49 |
| 2-28 | Inv | Ecoflash* | yes | yes | Methanesulfonic | ATA | 3.0 | 2 | 1 | X | | | | 23 |
| 2-29 | Inv | Ecoflash* | yes | yes | Methanesulfonic | ATA | 3.0 | 3 | 1 | X | | | | 21 |
| 2-30 | Inv | Ecoflash* | yes | yes | acetic | ATA | 3.0 | 3 | 0 | X | 6.2 | 5.9 | 4.2 | 25 |
| 2-31 | Inv | Ecoflash* | yes | yes | acetic | ATA | 3.0 | 3 | 3 | X | 6.7 | 6.4 | 4.8 | 13 |
| 2-32 | Inv | Ecoflash* | yes | yes | acetic | PTA | 0.2 | 4 | 3 | X | | | | 16 |
| 2-33 | Inv | Ecoflash* | yes | yes | citric | ATA | 0.5 | 3 | 1 | X | | | | 14 |
| 2-34 | Inv | Ecoflash* | yes | yes | acetic | ATA + PTA | 6.5 | 4 | 3 | X | | | | 16 |
| 2-35 | Inv | Ecoflash* | yes | yes | acetic | AAT | 1.0 | 3.3 | 1 | X | | | | 18 |
| 2-36 | Inv | Ecoflash* | yes | yes | acetic | AAT | 3.0 | 4.5 | 1 | X | | | | 17 |
| 2-37 | Comp | Ecoflash* | yes | yes | acetic | HB-tri | 4.5 | 3.3 | 0 | none | 6.5 | 5.0 | 2.0 | 70 |
| 2-38 | Inv | Ecoflash* | yes | yes | acetic | HB-tri | 4.5 | 3.3 | 0 | X | 5.2 | 4.7 | 3.5 | 21 |
| 2-39 | Comp | Ecoflash* | yes | yes | acetic | HB-tri | 4.5 | 3.3 | 1 | none | 6.6 | 5.5 | 2.0 | 68 |
| 2-40 | Inv | Ecoflash* | yes | yes | acetic | HB-tri | 4.5 | 3.3 | 1 | X | 6.0 | 5.2 | 4.1 | 16 |
| 2-41 | Comp | Ecoflash* | yes | yes | acetic | AMerc-tri | 3.4 | 3.3 | 0 | none | 5.2 | 4.0 | 1.7 | 83 |
| 2-42 | Comp | Ecoflash* | yes | yes | acetic | AMerc-tri | 3.4 | 3.3 | 0 | X | 4.4 | 4.1 | 3.3 | 34 |
| 2-43 | Comp | Ecoflash* | yes | yes | acetic | AMerc-tri | 3.4 | 3.3 | 1 | none | 4.0 | 1.7 | 0.3 | 180 |
| 2-44 | Comp | Ecoflash* | yes | yes | acetic | AMerc-tri | 3.4 | 3.3 | 1 | X | 4.5 | 3.0 | 2.0 | 200 |
| 2-45 | Comp | Ecoflash* | yes | yes | acetic | A-tri | 3.4 | 3.5 | 0 | none | 5.0 | 4.8 | 2.0 | 110 |
| 2-46 | Inv | Ecoflash* | yes | yes | acetic | A-tri | 3.4 | 3.5 | 0 | X | 4.5 | 4.3 | 3.4 | 23 |
| 2-47 | Comp | Ecoflash* | yes | yes | acetic | A-tri | 3.4 | 3.5 | 1 | none | 4.0 | 3.0 | 2.5 | 114 |
| 2-48 | Inv | Ecoflash* | yes | yes | acetic | A-tri | 3.4 | 3.5 | 1 | X | 4.8 | 4.3 | 3.1 | 20 |
| 2-49 | Comp | Ecoflash* | yes | yes | acetic | MercM-tetra | 3.4 | 3.1 | 0 | none | | | | 132 |
| 2-50 | Inv | Ecoflash* | yes | yes | acetic | MercM-tetra | 3.4 | 3.1 | 0 | X | | | | 19 |
| 2-51 | Comp | Ecoflash* | yes | yes | acetic | MercM-tetra | 3.4 | 3.1 | 1 | none | | | | 122 |
| 2-52 | Inv | Ecoflash* | yes | yes | acetic | MercM-tetra | 3.4 | 3.1 | 1 | X | | | | 18 |
| 2-53 | Comp | Ecoflash* | yes | yes | acetic | DMAE-tetra | 5.0 | 3.3 | 0 | none | | | | 105 |
| 2-54 | Inv | Ecoflash* | yes | yes | acetic | DMAE-tetra | 5.0 | 3.3 | 0 | X | | | | 30 |
| 2-55 | Comp | Ecoflash* | yes | yes | acetic | DMAE-tetra | 5.0 | 3.3 | 1 | none | | | | 114 |
| 2-56 | Comp | Ecoflash* | yes | yes | acetic | DMAE-tetra | 5.0 | 3.3 | 1 | X | | | | 40 |
| 2-57 | Inv | Cupraetch SR (0.5 µm)* | yes | yes | acetic | DMAE-tetra | 5.0 | 3.3 | 1 | none | | | | 21 |
| 2-58 | Inv | Cupraetch SR (0.5 µm)* | yes | yes | acetic | DMAE-tetra | 5.0 | 3.3 | 1 | X | | | | 16 |

| | | | | | | | | | | | | | | |
|---|---|---|---|---|---|---|---|---|---|---|---|---|---|---|
| (*) Products from Atotech Deutschland GmbH & Co. KG ATA: 5-amino tetrazole; PTA: 5-phenyl-1H-tetrazole; AAT: 1H-Tetrazole-5-acetic acid ; HB-tri: 1-Hydroxybenzotriazole hydrate, AMerc-tri: 3- Amino-5-mercapto-1,2,4-triazole, A-tri: 3-Amino-1,2,4-triazole, MercM-tetra: Mercapto-1-methyltetrazole, PTA. 5-Phenyl-1H-tetrazole; DMAE-tetra: 1-[2-(Dimethylamino)ethyl]-1H-tetrazole-5-thiol | | | | | | | | | | | | | | |

Adhesion promoter: examples in the table with a triazine concentration of 1.5 wt.% in the DEGBE: H₂O (1:1 ratio). DEGBE is a diethylene glycol monobutyl ether.

Peel strength done with GL102 35 µm, Halo measurements with GL102 of 15 µm

## Claims

1. A method for treating a surface of a metal, a metal alloy or a metal oxide comprising the following steps:
(i) providing a substrate, comprising the metal, metal alloy or metal oxide on at least one side of the substrate,
(ii) optionally, contacting the at least one section of said metal, metal alloy or metal oxide with a differential etching solution comprising one or more than one acid and one or more than one oxidizing agent,
(ii-bis) optionally, contacting at least one section of said metal, metal alloy or metal oxide with an alkaline cleaning solution,
(iii) contacting the at least one section of said metal, metal alloy or metal oxide with an acidic aqueous precoat solution comprising
(iii-a) one or more than one tetrazole and/or triazole compound of formulas (Ia) and/or (lb) 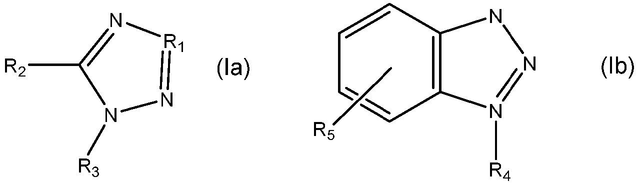
R₁: N, CH, C-NH₂;
R₂: NH₂, Ph, CH₂COOH, SH;
R₃: H, CH₃, CH₂CH₃, CH₂CH₂-NH₂, CH₂CH₂-N(CH₃)₂;
R₄: H, OH;
R₅: H, CH₃;
(iii-b) one or more than one organic and/or inorganic acid and/or salts thereof, and,
(iii-c) one or more than one peroxide in a total amount of 1.0 wt-% or less, based on the total weight of the precoat solution, and
(iii-d) halogenide ions in a total amount of 0 (0.00001) to 0.01 wt- %, based on the total weight of the precoat solution,
(iii-e) metal ions in a total amount of 0 (0.001) to 0.5 wt-%, based on the total weight of the precoat solution,
wherein during step (iii) the RSAI of said surface is not increased upon contacting with the precoat solution by more than 75%;
(iv) contacting at least one section of said metal, metal alloy or metal oxide with an acidic cleaning solution, preferably an acidic cleaning solution containing one or more than one acid, and optionally followed by rinsing of the at least one section of the metal, metal alloy or metal oxide,
(v) contacting of the at least one section of said metal, metal alloy or metal oxide with
one or more than one triazine compound of formula (II) 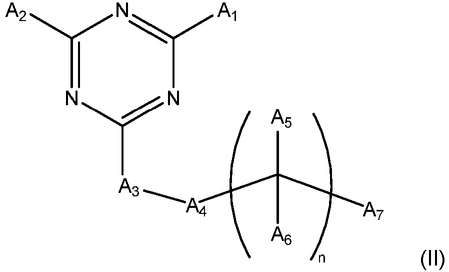 wherein
A₁ and A₂ are independently selected from the group consisting of NH₂, N(A₁₀)₂, NH(NH₂), NH(CH₂)ₒNH₂, SH, SCH₃, and OCH₃; where A₁₀ is and hydrogen atom or alkyl group having 1 to 12 atoms.
As is selected from the group consisting of -S-, -(CH₂)₂-S, -NH-(CH₂)ₘ- and -NH-(CH₂)ₘ-NH-;
A₄ is alkylene group which may content carbonyl, ethers, alpha-hydroxy ethers, carboxy, amide, imide, carbamide, carbamate groups
m is an integer in the range from 2 to 12,
n is an integer in the range from 2 to 12
o is an integer in the range from 2 to 12,
Wherein A₅ and A₆ may be the same or different and each represents a hydrogen atom, an alkyl group having 1 to 4 carbon atoms, a hydroxy group or a methoxy group,
Wherein A₇ may be a hydrogen atom, an alkyl group having 1 to 4 carbon atoms, a hydroxy group, a methoxy group or -Si(OAa)s group
A₈ independently denotes (CH₂-CH₂-O) ₚ-A₉, wherein independently
p is 0, 1, 2, 3, or 4, and
A₉ denotes H or C1 to C5 alkyl
(vi) optionally, baking the substrate, preferably at 130°C for 30 min;
(vii) applying an organic material such that the at least one section of the metal, metal alloy or metal oxide contacted with the triazine compound during step (v) is in contact with the applied organic material,
and
(viii) optionally, subjecting the substrate and the organic material to a heat treatment with a temperature in the range from 115°C to 420°C, preferably in the range from 125°C to 300°C, more preferably in the range from 130°C to 220°C,
wherein preferably the metal is copper, the metal alloy contains copper and the metal oxide is or contains a copper oxide;
with the proviso that the steps are performed in the listed order with the exception that step (iii) and step (iv) can be exchanged, i.e. step (iii) is carried out after steps (ii) and (ii-bis) and then followed by step (iv) or step (iv) is carried out after steps (ii) and (ii-bis) and then followed by step (iii); and
with the proviso that step (ii-bis) is mandatory if the method is carried out so that step (iv) is followed by step (iii).

2. The method according to claim 1, wherein the one or more tetrazole and/or triazole (iii-a) are selected from selected from 5-aminotetrazole (ATA), 5-phenyl-1H-tetrazole (PTA), 1H-Tetrazole-5-acetic acid (AAT), 1-[2-(Dimethylamino)ethyl]-1H-tetrazole-5-thiol (DMAE tetra), 3-amino-1,2,4-triazole (A-Tri), 3-amino-5-mercapto-1,2,4-triazole(A Marc-tri), tolyltriazole, 1-hydroxybenzotriazole (HB-tri) and mixtures thereof.

3. The method according to any of the precending claims, wherein the one or more than one organic and inorganic acid and/or salts thereof (iii-b) are selected from the group consisting of sulfuric, formic acid, acetic acid, lactic acid, malic acid, citric acid, and salts thereof, most preferably sulfuric acid, citric acid, acetic acid, and salts thereof.

4. The method according to any of the precending claims, wherein the one or more peroxide (iii-c) comprises hydrogen peroxide, preferably is hydrogen peroxide.

5. The method according to any of the preceding claims, wherein total amount of peroxides in the acidic aqueous non-etching solution is 1.0 wt-% or less, based on the total weight of the protector solution, preferably 0.9 wt-% or less, more preferably 0.8 wt-% or less, most preferably 0.7 wt-% or less, even most preferably 0.6 wt-% or less.

6. The method according to any of the preceding claims, wherein the halogenide ions (iii-d) are sources of chloride ions and/or bromide ions.

7. The method according to any of the preceding claims, wherein the metal ions (iii-e) are selected from copper and/or zinc compounds, and more preferably from copper (II) compounds.

8. The method according to any of the preceding claims wherein the metal is copper, the metal alloy contains copper and the metal oxide is or contains a copper oxide.

9. The method according to any of the preceding claims, where the triazine compound with formula (II), wherein A₇ is Si(OA₈)₃ group exhibiting a structure of formula (XI) 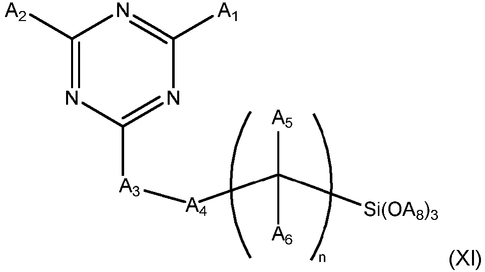
A₁ and A₂ are independently selected from the group consisting of NH₂, N(A₁₀)₂, NH(NH₂), NH(CH₂)ₒNH₂, SH, SCH₃, and OCH₃; where A₁₀ is and hydrogen atom or alkyl group having 1 to 12 atoms.
As is selected from the group consisting of -S-, -(CH₂)₂-S, -NH-(CH₂)ₘ- and -NH-(CH₂)ₘ-NH-;
A₄ is alkylene group which may content carbonyl, ethers, alpha-hydroxy ethers, carboxy, amide, imide, carbarmide, carbamate groups
m is an integer in the range from 2 to 12,
n is an integer in the range from 2 to 12
o is an integer in the range from 2 to 12,
Wherein A₅ and A₆ may be the same or different and each represents a hydrogen atom, an alkyl group having 1 to 4 carbon atoms, a hydroxy group or a methoxy group,
Wherein A₈ independently denotes (CH₂-CH₂-O) ₚ-A₉, wherein independently
p is 0, 1, 2, 3, or 4, and
A₈ denotes H or C1 to C5 alkyl.
